(19) Europäisches Patentamt
European Patent Office
Office européen des brevets

(11) EP 0 720 218 A2

(12) EUROPEAN PATENT APPLICATION

(43) Date of publication:
03.07.1996 Bulletin 1996/27

(51) Int. Cl.$^6$: H01L 21/76, H01L 29/10, H01L 29/78

(21) Application number: 95119309.3

(22) Date of filing: 07.12.1995

(84) Designated Contracting States:
AT DE FR GB IE IT NL

(30) Priority: 08.12.1994 US 351924

(71) Applicants:
- SIEMENS AKTIENGESELLSCHAFT
D-80333 München (DE)
- INTERNATIONAL BUSINESS MACHINES CORPORATION
Armonk, NY 10504 (US)

(72) Inventors:
- Alsmeier, Johann
Wappingers Falls, NY 12590 (US)
- Mandelman, Jack A.
Stormville, NY 12582 (US)

(74) Representative: Fuchs, Franz-Josef, Dr.-Ing.
Postfach 22 13 17
80503 München (DE)

# (54) Methods for reducing anomalous narrow channel effect in trench-bounded buried-channel p-MOSFETS

(57) Methods of manufacturing trench-bounded buried-channel p-type metal oxide semiconductor field effect transistors (p-MOSFETs), as used in dynamic random access memory (DRAM) technologies, for significantly reducing the anomalous buried-channel p-MOSFET sensitivity to device width. In one embodiment, the method comprises the initiation of a low temperature annealing step using an inert gas after the deep phosphorous n-well implant step, and prior to the boron buried-channel implant and 850°C gate oxidation steps. Alternatively, the annealing step may be performed after the boron buried-channel implant and prior to the 850°C gate oxidation step. In another embodiment, a rapid thermal oxidation (RTO) step is substituted for the 850°C gate oxidation step, following the deep phosphorous n-well and boron buried-channel implant steps. Alternatively, an 850°C gate oxidation step may follow the RTO gate oxidation step.

FIG. 1

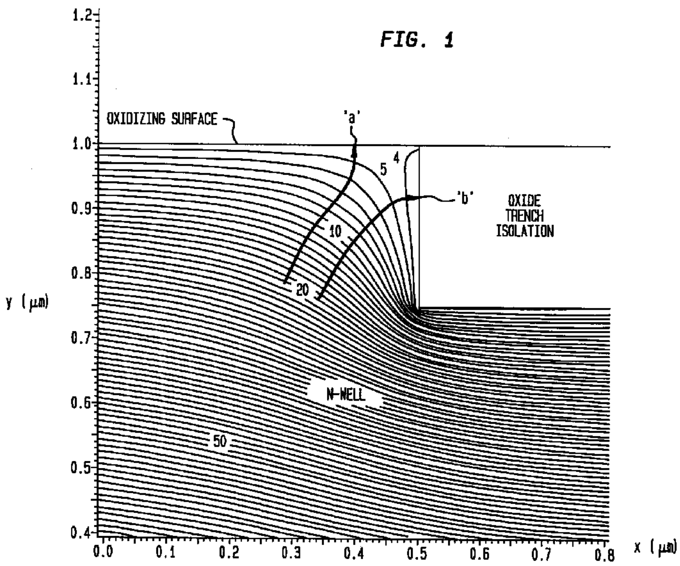


EP 0 720 218 A2

Printed by Rank Xerox (UK) Business Services
2.12.4/3.4

## Description

## BACKGROUND OF THE INVENTION

### Field of the Invention

The present invention generally relates to methods of manufacture of trench-bounded buried-channel p-type metal oxide semiconductor field effect transistors (p-MOSFETs) as used in dynamic random access memory (DRAM) technologies and, more particularly, to methods for significantly reducing the anomalous buried-channel p-MOSFET sensitivity to device width.

### Description of the Prior Art

Corner conduction in trench isolated n-channel MOSFETs, as reported by A. Bryant, W. Haensch, S. Geissler, J. Mandelman, D. Poindexter, and M. Steger in "The Current-Carrying Corner Inherent to Trench Isolation", *IEEE Electron Device Letters*, vol. 14, no. 8, pp. 412-414 (1993), and B. Davari, C. Koburger, T. Furukawa, Y. Taur, W. Noble, J. Warnock, and J. Mauer in "A Variable-Size Shallow Trench Isolation (STI) Technology with Diffused Sidewall Doping for Submicron CMOS", *1988 IEDM Technical Digest*, pp. 92-95 (1988), could be a significant contributor to standby current in low standby power ultra large scale integration (ULSI) applications. A manifestation of corner conduction is inverse narrow channel effect when the standard current definition of threshold voltage, $V_t$,

$$( I_{V_t} = 40 \times \left( \frac{W_{des}}{L_{des}} \right) nA ),$$

is applied, where $W_{des}$ and $L_{des}$ are the design width and design length of the device, respectively. Using $V_t$ defined by the above equation, inverse narrow channel effect is characterized by a decrease in the magnitude of $V_t$ as the width of the device decreases.

However, corner conduction in buried-channel p-MOSFETs has not, heretofore, been recognized as a concern. In buried-channel p-MOSFETs, the polarity of the work function difference between the N+ poly gate and the buried p-layer depletes the buried layer of carriers at low gate voltages. Due to the geometrically enhanced field at the silicon corner, it is expected that, when doping is uniform across the device width, the magnitude of $V_t$ at the corners of these devices is greater than at mid-channel. This leads to a normal channel effect, wherein the magnitude of $V_t$ increases with decreasing width of the device.

An anomalous (or inverse) narrow channel behavior has been observed in trench-bounded buried-channel p-MOSFETs (as used in contemporary DRAM technologies). Specifically, it has been observed that the magnitude of the threshold voltage, $V_t$, drops by approximately 100mV when going from a device width of 20µm down to 2µm. The magnitude of $V_t$ drops more rapidly with further width reduction to approximately 0.4µm. For devices narrower than 0.4µm, the expected normal narrow channel effect is observed, that is, the magnitude of $V_t$ increases with decreasing width of the device.

If the buried-channel boron dose is decreased to assure that the off-current is less than or equal to the objective over the entire range of design widths, the performance of the widest devices is compromised as a result of the higher than desired $V_t$. Consequently, to assure that the narrowest devices meet the off-current objective, the magnitude of the $V_t$ of the widest devices must be set higher than required by the off-current objective. This results in a performance penalty for the wider devices of typically a 100mV loss of overdrive.

## SUMMARY OF THE INVENTION

It is therefore an object of the present invention to provide a method of minimizing the anomalous channel effect and resulting sensitivity to device width.

To achieve these and other advantages and in accordance with the purpose of the invention embodied and broadly described herein, in one embodiment of the invention, there is provided a method for eliminating the anomalous channel effect including the steps of implanting at least one deep phosphorous n-well; initiating a low temperature anneal using an inert gas; implanting a boron buried-channel; and initiating a gate oxidation. The low temperature annealing step is performed at about 750°C to about 800°C, for a period of about 10 minutes to about 120 minutes, and utilizes an inert gas, such as, for example, nitrogen or argon. Alternatively, the low temperature anneal may be performed after implanting the boron buried-channel and prior to initiating the gate oxidation.

In another aspect of the invention, there is provided a method for eliminating the anomalous channel effect including the steps of implanting at least one deep phosphorous n-well; implanting a boron buried-channel; and initiating a rapid thermal oxidation (RTO) gate oxidation step. The RTO is performed at about 1025°C to about 1075°C for a period of time sufficient to grow the gate oxide. In still another aspect of the invention, the RTO step may be followed by a standard gate oxidation step performed at about 850°C.

It is to be understood that both the foregoing general description and the following detailed description are exemplary and explanatory and are intended to provide further explanation of the invention as claimed.

## BRIEF DESCRIPTION OF THE DRAWINGS

The foregoing and other objects, aspects and advantages will be better understood from the following detailed description of the embodiments of the invention with reference to the drawings, in which:

Figure 1 is a graph superimposed on a cross-section of a portion of an oxide trench isolation showing interstitial (excess) contours at the beginning of an 850°C gate oxidation step using process recipe "A";

Figure 2 is a cross-section similar to Figure 1 showing the boron buried layer puddle responsible for anomalous $V_t$ dependence on channel width using process recipe "A";

Figure 3 is a graph showing measured and modeled $V_t$ versus width (W) for process recipe "A" demonstrating the anomalous Vt dependence on width down to ≈0.4μm;

Figure 4 is a graph showing the effect on the anomalous narrow channel behavior of the solution using process recipe "B" according to the invention; and

Figure 5 is a graph showing the effect on the anomalous narrow channel behavior of the solution using process recipe "C" according to the invention.

## DETAILED DESCRIPTION OF AN EMBODIMENT OF THE INVENTION

In a standard 0.25μm CMOS process, a 15 minute, 850°C dry gate oxidation step immediately follows the n-well and boron buried-channel implants (referred to as process recipe "A"). As a result of damage from the deep phosphorous n-well implant ($2.5\times10^{13}cm^{-2}$, 500keV) used for latchup suppression, a high concentration source of excess interstitials is created approximately 0.8μm beneath the silicon surface. Since the trench sidewall and top surface of the device are efficient sinks for excess interstitials, an interstitial gradient, shown in Figure 1, is established. Heavy arrows 'a' and 'b' depict the direction of the interstitial flux.

The interstitial gradient towards the interfaces, driven by implant induced damage, is created despite interstitial injection at the oxidizing top surface. Under intrinsic diffusion conditions, the dependence of the boron flux on the excess interstitial concentration can be approximated as

$$\vec{J}_B = -D_B\left[\left(\frac{I}{I*}\right)\nabla B + B\nabla\left(\frac{I}{I*}\right)\right],$$

where $D_B$ is the boron diffusivity, and $\frac{I}{I^*}$ and B are the excess interstitial and boron concentrations, respectively.

Moving along the peak of the boron buried-layer (approximately 30nm deep) from trench edge towards mid-width, the excess interstitial concentration and, hence, the boron diffusivity, increase and the boron distribution broadens. The minimum in the peak net p-type concentration of the buried layer occurs at mid-width and is accentuated by the compensation of boron by the n-well doping. Furthermore, the gradient in the excess interstitial concentration drives the boron towards the trench edge. Within approximately 30nm of the trench edge, segregation induced boron depletion and n-type dopant pile-up reduce the net p-type concentration. The overall effect of the excess interstitial distribution on the diffusion of boron during the 850°C gate oxidation step is the creation of a "boron puddle" 100 near the trench edge, as shown by the simulated net doping distribution at the end of the process in Figure 2.

Modeling shows that the peak net p-type concentration in the "boron puddle" is approximately 32% greater than at mid-width, for a 2μm wide device. As the device width is reduced down to approximately 0.4μm, the peak net p-type concentration increases because of decreased interstitial concentration at the top surface resulting from recombination on the trench sidewall.

For still narrower devices, the effect of the n-type dopant pileup on the trench sidewall reduces the buried layer concentration. Figure 3 shows measured $V_t$ versus W (width) characteristics compared with simulated results. As illustrated in Figure 3, the magnitude of $V_t$ drops by approximately 150 mV when the device width is reduced from 2μm to 0.4μm. This results in a loss of overdrive of approximately 100mV for the widest channel p-FETS used in a design.

It is noteworthy that evidence of a comparable boron puddle for the n-MOSFET is neither observed experimentally nor predicted by modeling. As calculated using the implant damage model of G. Hobler and S. Selberherr in "Two-Dimensional Modeling of Ion Implantation Induced Point Defects", IEEE Trans. Computer-Aided Design, vol. 7, no. 2, pp. 174-181 (1988), damage from the deep boron implant ($2.0\times10^{13}cm^{-2}$, 260keV) used for latchup suppression in the n-MOSFET is significantly less than damage caused by the phosphorus implant in the p-MOSFET.

As noted above, part of the present process for making trench-bounded buried-channel p-MOSFETS (recipe "A")--comprising the following steps: (1) implanting at least one deep phosphorus n-well; (2) implanting a boron buried-channel; and (3) initiating a 850°C dry gate oxidation step--results in an anomalous narrow channel behavior.

It has been demonstrated that reduction of the anomalous narrow channel behavior can be achieved by implementing a low temperature annealing step, utilizing an inert gas, immediately following the deep phosphorus implant and prior to the boron buried-channel implant. Alternatively, the low temperature annealing step may be initiated after the boron buried-channel implant and prior to the 850°C dry gate oxidation step.

The low temperature anneal may be performed at a temperature of between about 750°C to about 800°C. Temperatures much above 800°C are undesirable as this will increase phosphorous diffusion. Temperatures much below 750°C result in reduced interstitial recombination. Regarding the duration of the annealing step, a reduction of the anomalous narrow channel behavior has been observed for periods ranging from about 10 minutes to about 120 minutes. The low temperature anneal is carried out with an inert gas, such as, by way of example and not by limitation, nitrogen or argon.

This annealing process results in rapid excess interstitial recombination on the $Si/SiO_2$ interfaces; thus the transient enhanced diffusion (TED) of boron is greatly reduced during the subsequent 850°C gate oxidation. Figure 4 compares the simulated and measured $V_t$ vs. W characteristics for devices fabricated using recipe "B" with simulated behavior using recipe "A". As shown in Figure 4, the threshold voltage $V_t$ remains nearly constant as the device width is reduced from about 2µm to about 0.4µm. Specifically, the net p-type concentration peaks only 3% above mid-width value for a device width of 2µm. The normal narrow channel behavior--increased magnitude of $V_t$ with decreasing W--is observed at device widths below about 0.4µm.

Although the addition of this low temperature inert gas annealing step results in a drastically reduced "boron puddle" it also results in a lower magnitude of wide device $V_t$, since the reduced transient enhanced diffusion (TED) of boron leaves a higher peak net p-type concentration in the buried layer.

## DETAILED DESCRIPTION OF ANOTHER EMBODIMENT OF THE INVENTION

In another embodiment of the invention, it has also been demonstrated that reduction of the anomalous narrow channel behavior can be achieved by substituting a rapid thermal oxidation (RTO) step for the 850°C gate oxidation step (recipe "A") following the deep phosphorous implant. The RTO gate oxidation step (referred to as process recipe "C") is carried out at temperatures ranging from about 1025°C to about 1075°C. The duration of the RTO gate oxidation step is dependent upon the desired thickness of the gate oxide. For example, for a gate oxide thickness of 80 angstroms, the duration of the RTO gate oxidation step would be about 1.3 minutes.

Alternatively, rather the substitute the RTO gate oxidation step for the 850°C gate oxidation step, the two can be used in conjunction, with the duration of the RTO step being reduced somewhat to be followed by the 850°C gate oxidation step.

During the RTO gate oxidation step, transient enhanced diffusion (TED) of boron is negligible, since the excess interstitial concentration is reduced at the elevated temperature. Figure 5 compares the simulated $V_t$ vs. W characteristics for devices fabricated using recipe "C" with simulated behavior using recipe "A". As shown in Figure 5, the threshold voltage $V_t$ remains nearly constant as the device width is reduced from about 2µm to about 0.4µm. The normal narrow channel behavior is observed at device widths below about 0.4µm. Simulation shows the magnitude of the "boron puddle" and the anomalous $V_t$ width dependence are negligible for this process.

While the invention has been described in terms of the above embodiments, those skilled in the art will recognize that the invention can be practiced with modification within the spirit and scope of the appended claims.

## Claims

Having thus described my invention, what I claim as new and desire to secure by Letters Patent is as follows:

1. A method for reducing an anomalous narrow channel effect in trench-bounded buried-channel p-MOSFETS, the method comprising the steps of:
   implanting at least one deep phosphorous n-well;
   performing one of initiating a low temperature anneal using an inert gas or implanting a boron buried-channel;
   performing the other of initiating a low temperature anneal using an inert gas or implanting a boron buried-channel; and
   initiating a dry gate oxidation.

2. The method recited in claim 1, wherein the annealing step is performed between a temperature of about 750°C to about 800°C, for a period of about 10 minutes to about 120 minutes, and the inert gas is nitrogen or argon.

3. The method recited in claim 1, wherein the dry gate oxidation is performed at a temperature of about 850°C.

4. A method for reducing an anomalous narrow channel effect in trench-bounded buried-channel p-MOSFETS, the method comprising the steps of:
   implanting a deep phosphorous n-well;
   implanting a boron buried-channel; and
   initiating a rapid thermal oxidation (RTO) gate oxidation.

5. The method recited in claim 4, wherein the rapid thermal oxidation step is performed at between about 1025°C to about 1075°C for a period of time sufficient to grow a desired gate oxide thickness.

6. The method recited in claim 4, further including an 850°C gate oxidation step following the RTO gate oxidation step.

FIG. 1

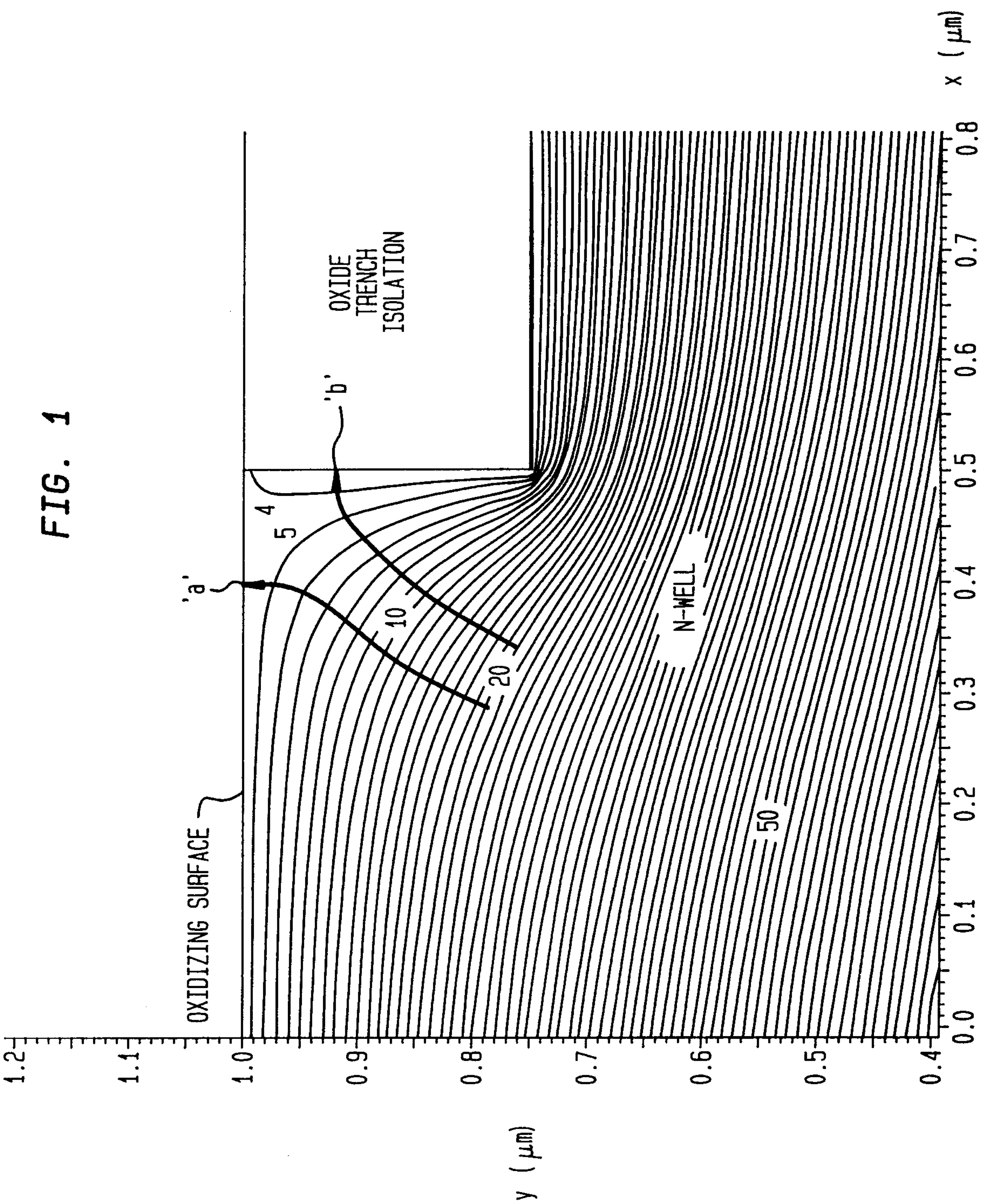
OXIDIZING SURFACE
OXIDE
TRENCH
ISOLATION
N-WELL
'a'
'b'
4
5
10
20
50
x (μm)
y (μm)
0.0
0.1
0.2
0.3
0.4
0.5
0.6
0.7
0.8
0.4
0.5
0.6
0.7
0.8
0.9
1.0
1.1
1.2

FIG. 2

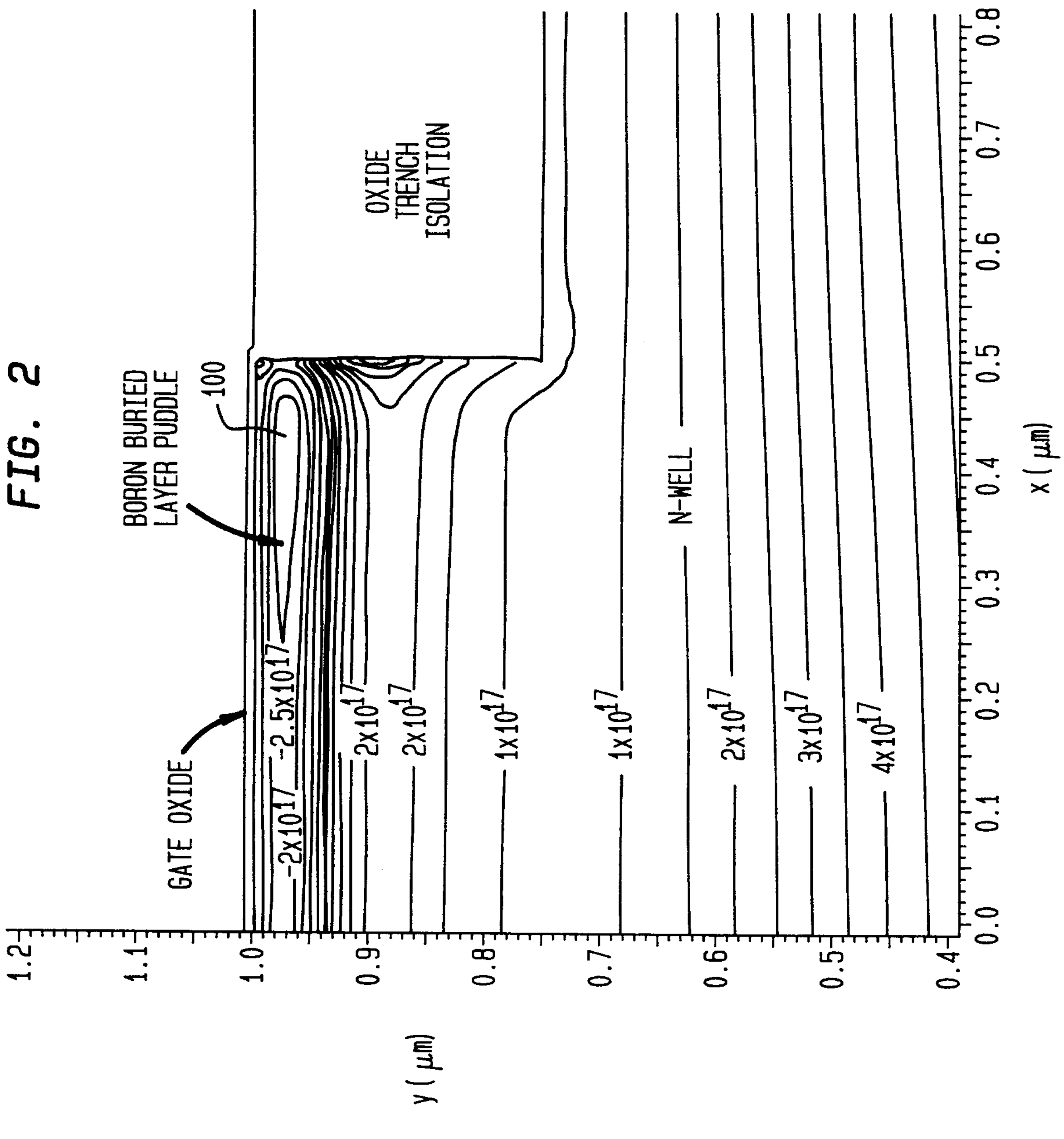
BORON BURIED LAYER PUDDLE
100
GATE OXIDE
OXIDE TRENCH ISOLATION
N-WELL
-2x10^17
-2.5x10^17
2x10^17
2x10^17
1x10^17
1x10^17
2x10^17
3x10^17
4x10^17
x ( μm)
y ( μm)
0.0
0.1
0.2
0.3
0.4
0.5
0.6
0.7
0.8
1.2
1.1
1.0
0.9
0.8
0.7
0.6
0.5
0.4

FIG. 3

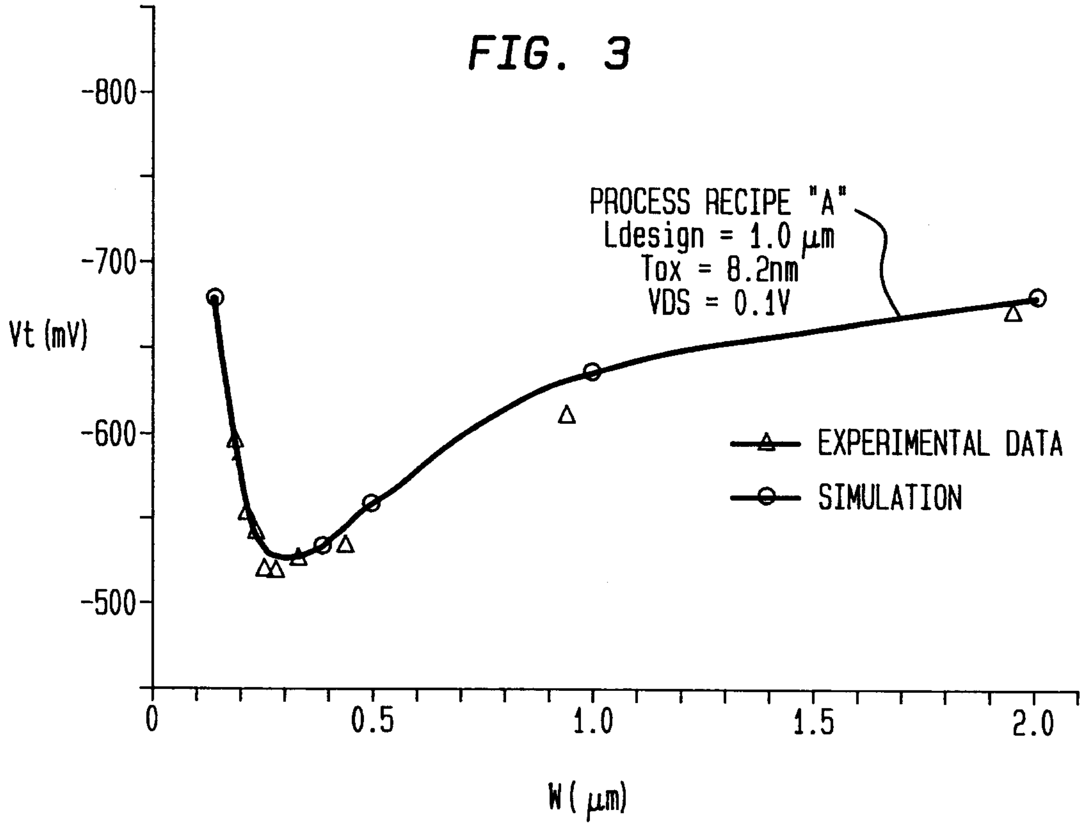

-800
-700
-600
-500
Vt (mV)
PROCESS RECIPE "A"
Ldesign = 1.0 μm
Tox = 8.2nm
VDS = 0.1V
EXPERIMENTAL DATA
SIMULATION
0
0.5
1.0
1.5
2.0
W ( μm)


FIG. 4

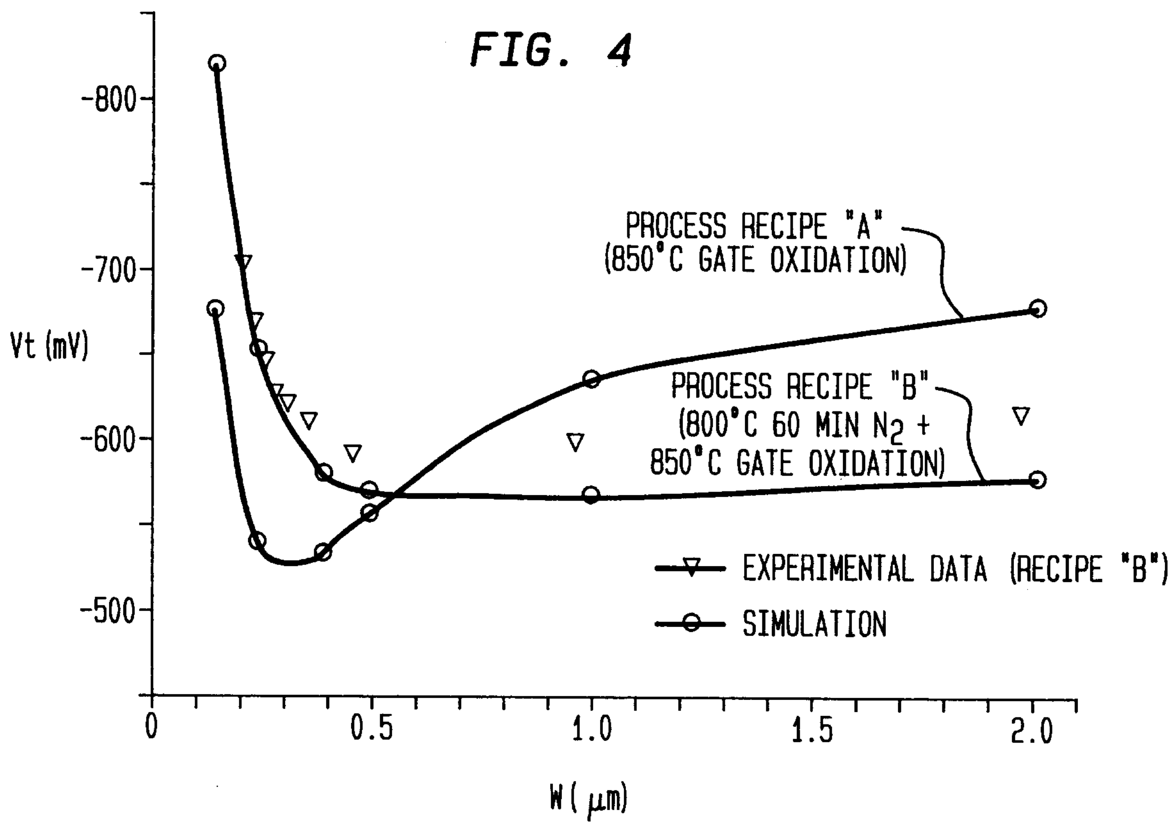

-800
-700
-600
-500
Vt (mV)
PROCESS RECIPE "A"
(850°C GATE OXIDATION)
PROCESS RECIPE "B"
(800°C 60 MIN N2 +
850°C GATE OXIDATION)
EXPERIMENTAL DATA (RECIPE "B")
SIMULATION
0
0.5
1.0
1.5
2.0
W ( μm)

FIG. 5

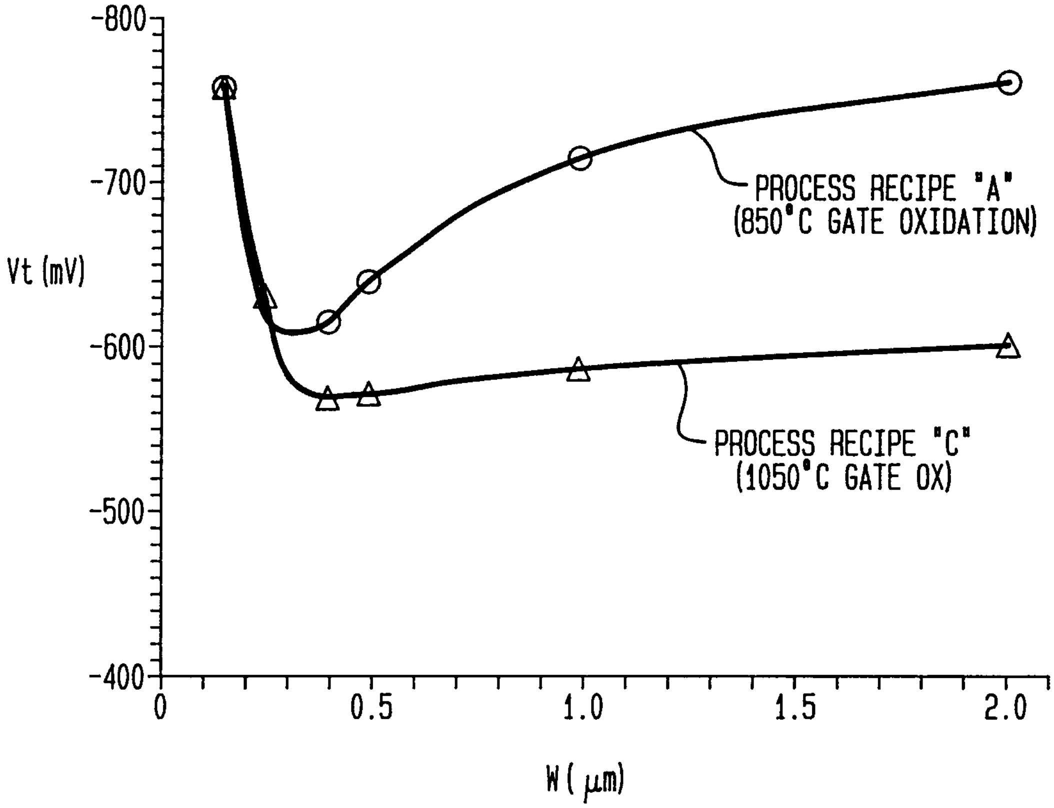
-800
-700
-600
-500
-400
Vt (mV)
0
0.5
1.0
1.5
2.0
W ( μm)
PROCESS RECIPE "A"
(850°C GATE OXIDATION)
PROCESS RECIPE "C"
(1050°C GATE OX)